# EUROPEAN PATENT APPLICATION

(11) **EP 2 615 633 A1**
(43) Date of publication of application: **17.07.2013**
(21) Application number: 11823588.6
(22) Date of filing: 07.09.2011
(51) Int. Cl.: H01L 21/304, C09K 3/18

(54) **COMPOSITION FOR WATER-REPELLENT TREATMENT OF SURFACE, AND METHOD FOR WATER-REPELLENT TREATMENT OF SURFACE OF SEMICONDUCTOR SUBSTRATE USING SAME**

(30) Priority: 08.09.2010 JP 2010201276
(71) Applicant: Wako Pure Chemical Industries, Ltd., Osaka-shi Osaka 540-8605 (JP)
(72) Inventor: MIZUTA Hironori, Kawagoe-shi Saitama 350-1101 (JP); URANO Yoji, Kawagoe-shi Saitama 350-1101 (JP); KAKIZAWA Masahiko, Kawagoe-shi Saitama 350-1101 (JP)
(74) Representative: Hinkelmann, Klaus
(86) International application number: PCT/JP2011/070328
(87) International publication number: WO 2012/033114

(57) **Abstract**

The purpose of the present invention to provide: a composition which can be used for water-repellent treating of the entire surface of a semiconductor substrate having a pattern formed by laminating a Si-containing insulating layer and a metal layer, at one time; and a method for water-repellent treatment of the semiconductor substrate surface using the composition.

The present invention relates to: (1) a composition for water-repellent treatment of a semiconductor substrate surface comprising a) at least one kind of a compound selected from the group consisting of a long-chain alkyl tertiary amine and a long-chain alkyl ammonium salt, b) a base or an acid generating agent, having a condensed ring structure or forming a condensed ring structure by generating a base or an acid and c) a polar organic solvent, and (2) a method for water-repellent treatment of the semiconductor substrate surface having the pattern formed by laminating the Si-containing insulating layer and the metal layer, using the composition.

## Description

### TECHNICAL FIELD

The present invention relates to a composition for water-repellent treatment of a semiconductor substrate surface having a pattern structure with high aspect ratio, and a method for water-repellent treatment of a semiconductor substrate surface using the same.

### BACKGROUND ART

In a manufacturing process of a semiconductor substrate, with tendency toward making a finer wiring in recent years, it has been required to form a pattern having increased height as compared with line width, so called, high aspect ratio. In the case of such a pattern having high aspect ratio, a problem has been caused that a pattern collapses by influence of surface tension of water in a rinsing step using pure water. This tendency has become large in forming a pattern by lamination of a Si-containing insulating layer of, in particular, a SiO₂ layer or the like, and a metal layer.
As a conventional method for water-repellent treatment, there has been known a method for water-repellent treatment, as for a Si-containing insulating layer of, for example, a SiO₂ layer or the like, or a silicon wafer, using a solution containing various fluorine compounds (PATENT LITERATURE 1 or the like), using gas of various kinds of fluorine compounds (PATENT LITERATURE 2, PATENT LITERATURE 3 or the like), or the like.
However, because the Si-containing insulating layer such as a SiO₂ layer and the metal layer have different surface properties thereof, there has not been known a composition enabling water-repellent treatment of these two layers at the same time efficiently, and it is a state that development thereof has been desired.

### PRIOR ART LITERATURES

### PATENT LITERATURE

PATENT LITERATURE 1: JP-A-9-203803
PATENT LITERATURE 2: WO 99/48339
PATENT LITERATURE 3: JP-A-2003-257655

### DISCLOSURE OF INVENTION

### TECHNICAL PROBLEM

The present invention has been proposed to solve the problems described above, and it is an object of the present invention to provide a composition to be used for performing, at one time, water-repellent treatment of the entire surface of a semiconductor substrate having a pattern formed by lamination of a Si-containing insulating layer such as a SiO₂ layer and a metal layer, and a method for water-repellent treatment of the semiconductor substrate surface, having the pattern formed by lamination of the Si-containing insulating layer, and the metal layer, using the composition thereof.

### TECHNICAL SOLUTION

To solve the above problems, the present invention is composed of the following constitution.
(1) A composition for water-repellent treatment of a semiconductor substrate surface, comprising a) at least one kind of a compound selected from the group consisting of a long-chain alkyl tertiary amine and a long-chain alkyl ammonium salt, b) a base or an acid generating agent, having a condensed ring structure or forming a condensed ring structure by generating a base or an acid and c) a polar organic solvent.
(2) A method for water-repellent treatment of a semiconductor substrate surface, characterized by treating the semiconductor substrate having a pattern formed by lamination of a Si-containing insulating layer and a metal layer, using the composition of the above (1), under irradiation of light having a wavelength of 200 nm or longer, or under heating.

That is, the present inventors have intensively studied to discover a composition enabling water-repellent treatment, by one time treatment, of surface of semiconductor substrate, having a pattern with increased height as compared with line width, so called, high aspect ratio, wherein the pattern is formed by lamination of a Si-containing insulating layer such as a SiO₂ layer and a metal layer, and as a result, discovered that, by using the composition of the above (1), it is possible to perform water-repellent treatment of the semiconductor substrate surface, having the pattern formed by lamination of the Si-containing insulating layer such as the SiO₂ layer and the metal layer, simply and conveniently, as well as efficiently, and have thus completed the present invention.

### ADVANTAGEOUS EFFECTS

By using the composition for water-repellent treatment of the present invention, and a method for water-repellent treatment of a semiconductor substrate surface using the composition, it is possible to perform water-repellent treatment, by one time treatment, of semiconductor substrate surface, having a pattern with increased height as compared with line width, so called, high aspect ratio, wherein the pattern is formed by lamination of a Si-containing insulating layer such as a SiO₂ layer and the metal layer, therefore a problem that, for example, a pattern collapses by influence of surface tension of water in a rinsing step using pure water, which has been a problem of such a substrate, can be prevented.

### DESCRIPTION OF EMBODIMENTS

(a) At least one kind of the compound selected from the group consisting of a long-chain alkyl tertiary amine and a long-chain alkyl ammonium salt, relevant to the present invention, preferably includes the one represented by the following general formula (1) or the general formula (2); 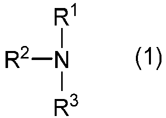 (wherein R¹ to R³ each independently represent an alkyl group having 1 to 20 carbon atoms, an aryl group having 6 to 10 carbon atoms, or an aralkyl group having 7 to 12 carbon atoms, provided that at least one among R¹ to R³ is an alkyl group having 4 to 20 carbon atoms), 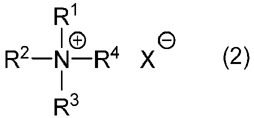 (wherein R¹ to R⁴ each independently represent an alkyl group having 1 to 20 carbon atoms, an aryl group having 6 to 10 carbon atoms, or an aralkyl group having 7 to 12 carbon atoms, and X- represents an anion, provided that at least one among R¹ to R⁴ is an alkyl group having 4 to 20 carbon atoms).

In the general formula (1) or (2), an alkyl group having 1 to 20 carbon atoms, represented by R¹ to R⁴, is preferably a linear or branched alkyl group, and specifically, includes, for example, a methyl group, an ethyl group, a n-propyl group, an isopropyl group, a n-butyl group, an isobutyl group, a sec-butyl group, a tert-butyl group, a n-pentyl group, an isopentyl group, a sec-pentyl group, a tert-pentyl group, a neopentyl group, a 2-methylbutyl group, a 1,2-dimethylpropyl group, a 1-ethylpropyl group, a n-hexyl group, an isohexyl group, a sec-hexyl group, a tert-hexyl group, a neohexyl group, a 2-methylpentyl group, a 1,2-dimethylbutyl group, a 2,3-dimethylbutyl group, a 1-ethylbutyl group, a n-heptyl group, an isoheptyl group, a sec-heptyl group, a tert-heptyl group, a neoheptyl group, a n-octyl group, an isooctyl group, a sec-octyl group, a tert-octyl group, a neooctyl group, a 2-ethylhexyl group, a n-nonyl group, an isononyl group, a sec-nonyl group, a tert-nonyl group, a neononyl group, a n-decyl group, an isodecyl group, a sec-decyl group, a tert-decyl group, a neodecyl group, a n-undecyl group, a n-dodecyl group, a n-tridecyl group, a n-tetradecyl group, a n-pentadecyl group, a n-hexadecyl group, a n-heptadecyl group, a n-octadecyl group, a n-nonadecyl group, a n-icosyl group, or the like, and among them, the linear alkyl group is preferable, among them, the linear alkyl group having 4 to 14 carbon atoms is more preferable, and the linear alkyl group having 6 to 14 carbon atoms is furthermore preferable.

In the general formula (1) or (2), an aryl group having 6 to 10 carbon atoms, represented by R¹ to R⁴, may be any of a monocyclic, or a condensed polycyclic, and specifically, includes, for example, a phenyl group, a naphthyl group, an azulenyl group, or the like, and among them, a phenyl group having 6 carbon atoms is preferable.

In the general formula (1) or (2), an aralkyl group having 7 to 12 carbon atoms, represented by R¹ to R⁴, may be any of a monocyclic, or a condensed polycyclic, and specifically, includes, for example, a benzyl group, a phenethyl group, an α-methylbenzyl group, a 3-phenylpropyl group, a 1-methyl-1-phenylethyl group, a 4-phenylbutyl group, a 2-methyl-2-phenylpropyl group, a 1,2,3,4-tetrahydronaphthyl group, a naphthylmethyl group, a 2-naphthylethyl group, or the like, and among them, a benzyl group having 7 carbon atoms is preferable.

in the general formula (2), an anion represented by X- is not especially limited, as long as it is the one usually used for such an object in this field, and preferably includes a halide ion such as, for example, a fluoride ion, a chloride ion, a bromide ion, an iodide ion; an anion derived from a sulfonic acid such as, for example, a methanesulfonic acid, an ethanesulfonic acid; an anion derived from carboxylic acid such as for example, a formic acid, an acetic acid, a propionic acid, a butyric acid, or the like; a hydroxide ion, or the like.

Among the tertiary amines represented by the general formula (1), the one where all of R¹ to R³ is a linear alkyl group having 4 to 14 carbon atoms, is preferable, and among them, the one where all of R¹ to R³ is a linear alkyl group having 6 to 14 carbon atoms, is more preferable.

Among the quaternary ammonium salts represented by the general formula (2), the one where at least one of R¹ to R⁴ is a linear alkyl group having 4 to 14 carbon atoms, is preferable, and among them, the one where at least one of R¹ to R⁴ is a linear alkyl group having 6 to 14 carbon atoms, is more preferable.

When compared with the tertiary amines represented by the general formula (1) and the quaternary ammonium salts represented by the general formula (2), the quaternary ammonium salts represented by the general formula (2) are preferable.

As the tertiary amines represented by the general formula (1), for example, tri-n-butylamine, tri-n-octylamine, tri-n-dodecylamine, and the like are particularly preferable.

As the quaternary ammonium salts represented by the general formula (2), for example, tri-n-octylmethylammonium chloride, tri-n-octylmethylammonium bromide, tri-n-octylmethylammonium iodide, tetra-n-octylammonium chloride, tetra-n-octylammonium bromide, tetra-n-octylammonium iodide, benzyldimethyl-n-tetradecylammonium chloride, benzyldimethyl-n-tetradecylammonium bromide, benzyldimethyl-n-tetradecylammonium iodide, and the like are particularly preferable.

As for these long-chain alkyl tertiary amines and long-chain alkyl ammonium salts, only one kind among them may be used, or two or more kinds may be used in combination, as appropriate. In addition, concentration of these long-chain alkyl tertiary amines and long-chain alkyl ammonium salts in the composition is usually 0.001 to 0.3 mol/L, preferably 0.001 to 0.1 mol/L, and more preferably 0.001 to 0.05 mol/L.
As these long-chain alkyl tertiary amines and long-chain alkyl ammonium salts, a commercial product may be used, or the one synthesized in accordance with a conventional method usually used in this field, as appropriate, may be used.

The base or the acid generating agent, having the condensed ring structure, or forming the condensed ring structure by generating the base or the acid, relevant to the present invention is (i) the one generating a base or an acid by irradiation of light with a wavelength of 200 nm or longer (activation energy rays), more specifically, light with a wavelength of 200 nm to 500 nm (activation energy rays), or the one generating a base or an acid by heating, and (ii) the one having a condensed ring structure where two or more monocyclic rings (aliphatic rings or aromatic rings) are condensed in addition to a part to become a base or an acid generated by light irradiation or heating, or the one forming condensed ring structure where two or more monocyclic rings (aliphatic rings or aromatic rings) are condensed by generation of a base {in other words, the one having a condensed ring structure where two or more monocyclic rings (aliphatic rings or aromatic rings) are condensed at the remaining part after the base or the acid is released by light irradiation or heating}. The condensed ring structure is the one having a planer structure of an anthracene ring, a naphthalene ring, a pyrene ring, an anthraquinone ring, a thioxanthone ring, an acenaphthene ring, a coumarin ring, a xanthone ring or the like. Among these base or acid generating agents, the base generating agent is preferable.

The base or the acid generating agents, having the condensed ring structure, or forming the condensed ring structure by generating the base or the acid, relevant to the present invention, includes more preferably the base generating agent represented by the following general formula (3); 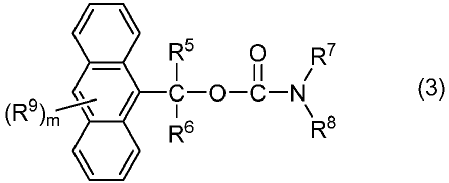 (wherein R⁵ and R⁶ each independently represent a hydrogen atom or an alkyl group having 1 to 10 carbon atoms; R⁷ and R⁸ each independently represent a hydrogen atom, an alkyl group having 1 to 10 carbon atoms, or R⁷ and R⁸ form an aliphatic hetero ring or an aromatic hetero ring including the nitrogen atom to which they are bound, said an aliphatic hetero ring or an aromatic hetero ring having 3 to 8 carbon atoms which may have substituent(s); m moieties of R⁹ each independently represent a halogen atom or an alkyl group having 1 to 10 carbon atoms; and m represents an integer of 0 to 9.).

In the general formula (3), the alkyl group having 1 to 10 carbon atoms, represented by R⁵ to R⁹, includes a linear, branched or cyclic alkyl group, specifically includes, for example, a methyl group, an ethyl group, a n-propyl group, an isopropyl group, a n-butyl group, an isobutyl group, a sec-butyl group, a tert-butyl group, a cyclobutyl group, a n-pentyl group, an isopentyl group, a sec-pentyl group, a tert-pentyl group, a neopentyl group, a 2-methylbutyl group, a 1,2-dimethylpropyl group, a 1-ethylpropyl group, a cyclopentyl group, a n-hexyl group, an isohexyl group, a sec-hexyl group, a tert-hexyl group, a neohexyl group, a 2-methylpentyl group, a 1,2-dimethylbutyl group, a 2,3-dimethylbutyl group, a 1-ethylbutyl group, a cyclohexyl group, a n-heptyl group, an isoheptyl group, a sec-heptyl group, a tert-heptyl group, a neoheptyl group, a cycloheptyl group, an n-octyl group, an isooctyl group, a sec-octyl group, a tert-octyl group, a neooctyl group, a 2-ethylhexyl group, a cyclooctyl group, a n-nonyl group, an isononyl group, a sec-nonyl group, a tert-nonyl group, a neononyl group, a cyclononyl group, a n-decyl group, an isodecyl group, a sec-decyl group, a tert-decyl group, a neodecyl group, a cyclodecyl group, or the like, and among them, a linear or cyclic alkyl group is preferable, and specifically, a methyl group, an ethyl group, a n-propyl group, a n-butyl group, a cyclobutyl group, a n-pentyl group, a cyclopentyl group, a n-hexyl group, or a n-cyclohexyl group is preferable.

In the general formula (3), the one represented by R⁷ and R⁸, which forms an aliphatic hetero ring or an aromatic hetero ring including the nitrogen atom to which they (R⁷ and R⁸) are bound, said an aliphatic hetero ring or an aromatic hetero ring having 3 to 8 carbon atoms which may have substituent(s), includes an aliphatic hetero ring including the nitrogen atom, said an aliphatic hetero ring having 3 to 8 carbon atoms which may have substituent(s), such as, for example, azetidine, pyrrolidine, piperidine, hexamethyleneimine (azepane), heptamethyleneimine (azocane), octamethyleneimine (azonane), 2,5-diethylpyrrolidine, 2,6-dimethylpiperidine, 2,4,6-trimethylpiperidine, 4-hydroxypiperidine, 4-mercaptopiperidine, 4-nitropiperidine, 4-cyanopiperidine, oxazolidine, thiazolidine, morpholine, thiomorpholine, 2,3,5,6-tetramethylmorpholine, 2,3,5,6-tetramethyltiomorpholine; an aromatic hetero ring including the nitrogen atom, said an aromatic hetero ring having 3 to 8 carbon atoms which may have substituent(s), such as, for example, pyrrole, imidazole, pyrazole, 2,5-dimethylpyrrole, 2,5-diethylpyrrole, 2,5-dimethylimidazole, 2,5-diethyl-imidazole, 3,5-dimethylpyrazole, 3,5-diethylpyrazole, and among them, piperidine, 4-hydroxypiperidine and imidazole are preferable.

In the general formula (3), the halogen atom represented by R⁹ includes specifically, for example, a fluorine atom, a chlorine atom, a bromine atom, an iodine atom, or the like, and among them, a chlorine atom and a bromine atom are preferable, and a bromine atom is more preferable.

In the general formula (3), m is preferably an integer of 0 to 5, and among them, an integer of 0 to 3 is more preferable, and 0 is still more preferable.

A preferable specific example of the base generating agent, having the condensed ring structure or forming the condensed ring structure by generating the base, represented by the general formula (3) includes, for example, 9-anthrylmethyl 1-piperidinecarboxylate or the like.

As such base or acid generating agents, various kinds have been synthesized and filed a patent application by Wako Pure Chemical Industries, Ltd. to which the present inventor et. al. belong, therefore those synthesized as appropriate based on corresponding description in the patent application, may be used.

For example, a specific example of the base generating agent is as follow.

1) About the base generating agent, having any of the condensed ring structure selected from an anthraquinone ring, a pyrene ring, an anthracene ring, and a naphthalene ring, at the remaining part after the base is released by light irradiation or heating.
Among such a base generating agent, the one having any of the condensed ring structures selected from an anthraquinone ring, a pyrene ring, and an anthracene ring has been disclosed in WO 2010/064631.
In addition, the one having the condensed ring structure made of a naphthalene ring may be synthesized in accordance with a method described in Synthetic Example 1 and Example 1 of WO 2010/064631. That is, firstly, 1-(or 2-)naphthylmethyl 4'-nitrophenyl carbonate is obtained by operating similarly using the same reagents as in the Synthetic Example 1, except that 1-naphthalenemethanol or 2-naphthalenemethanol was used instead of 9-anthracenemethanol of the Synthetic Example 1, and next, 1-(or 2-)naphthylmethyl 1-piperidinecarboxylate may be synthesized by operating similarly using the same reagents as in the Example 1, except by using this instead of 9-anthrylmethyl 4'-nitrophenylcarbonate of the Example 1.

2) About the base generating agent, having any of the condensed ring structures selected from a thioxanthone ring and a xanthone ring, at the remaining part after the base is released by light irradiation or heating.
Among such base generating agents, the one having the condensed ring structure made of the thioxanthone ring has been disclosed in WO 2010/064632.
In addition, the one having the condensed ring structure made of a xanthone ring may be synthesized in accordance with a method described in Synthetic Examples 1 to 3 and Examples 1 to 7 of WO 2010/064632. That is, firstly, 7-bromo-2,4-diethyl-9H-xanthene-9-one is obtained by operating similarly using the same reagents as in the Synthetic Example 1, except that 2,4-diethyl-9H-xanthene-9-one was used instead of 2,4-diethyl-9H-thioxanthene-9-one of the Synthetic Example 1, and next, 2,4-diethyl-7-(3-hydroxy-propyl-1-yl)-9H-xanthene-9-one may be obtained by operating similarly using the same reagents as in the Example 1, except by using this instead of 7-bromo-2,4-diethyl-9H-xanthene-9-one of the Example 2, and still more, 2,4-diethyl-7-[3-(N,N-diethylcarbamoyloxy)-1-propyl-1-yl]-9H-xanthene-9-one may be obtained by operating similarly using the same reagents as in the Example 1, except by using this instead of 2,4-diethyl-7-(3-hydroxy-propyl-1-yl)-9H-thioxanthene-9-one.

3) About the base generating agent, having the condensed ring structure made of an alkoxyanthracene ring, at the remaining part after the base is released by light irradiation or heating.
It has been disclosed in Japanese Patent Application No. 2010-135818.

4) About the base generating agent, having the condensed ring structure made of an acenaphthene ring and a coumarin ring, at the remaining part after the base is released by light irradiation or heating.
It has been disclosed in Japanese Patent Application No. 2010-168117.

The specific examples of such a base generating agent are exemplified below, however, it is not that these only can be used in the present invention, but those within a range described in the above 4 application descriptions may also be used in the present invention.

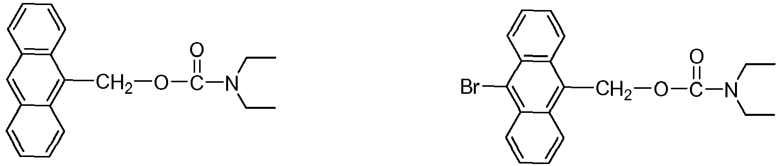

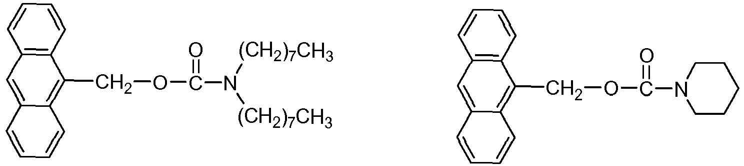

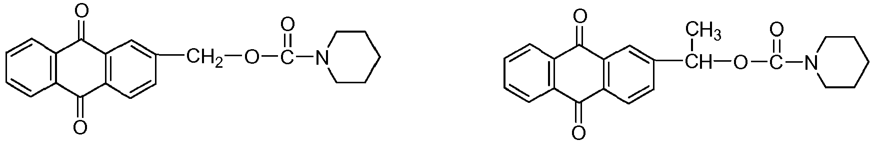

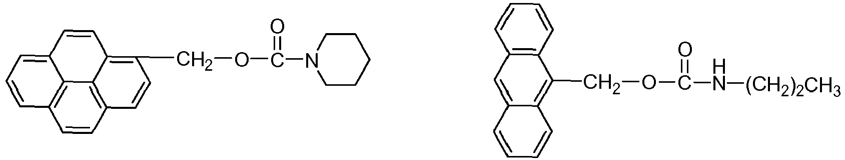

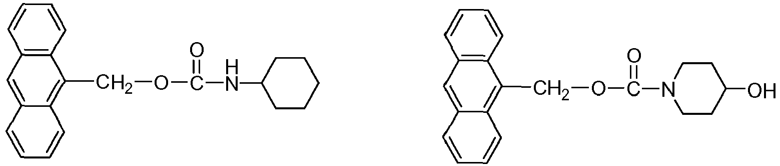

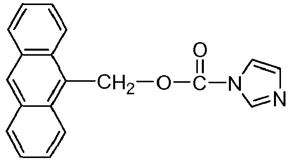

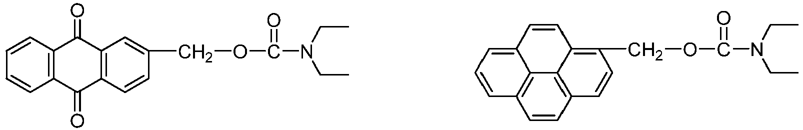

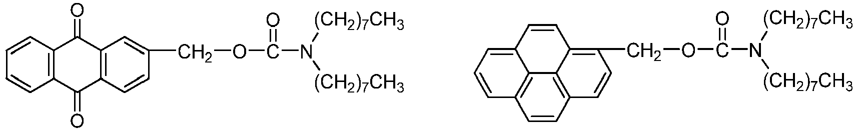

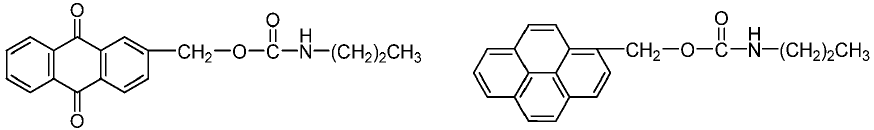

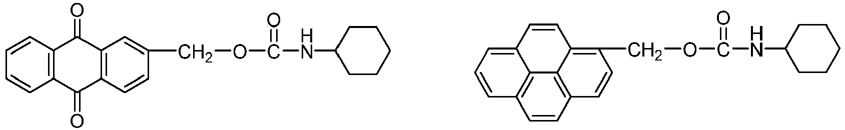

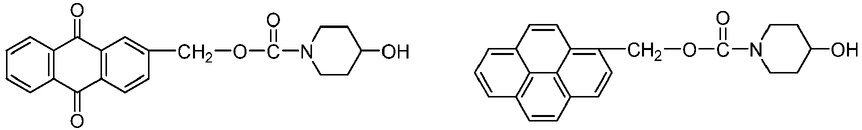

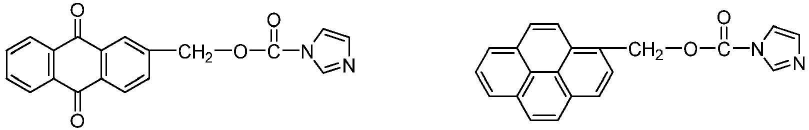

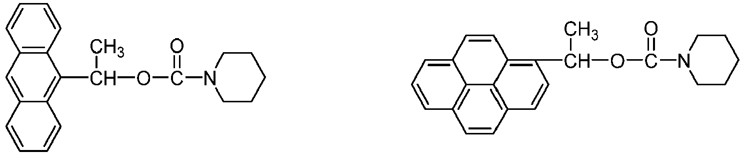

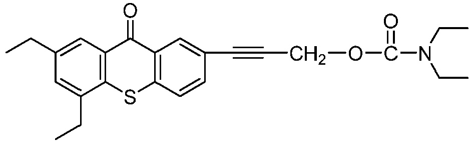

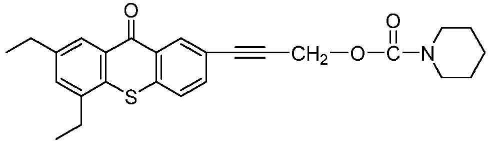

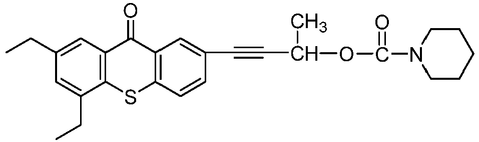

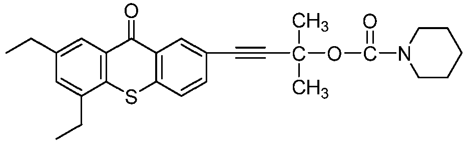

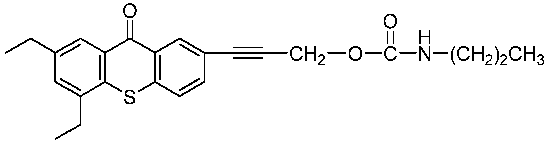

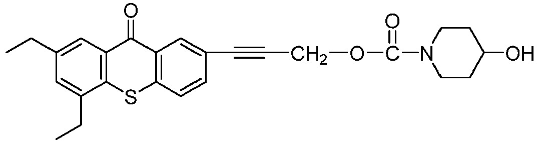

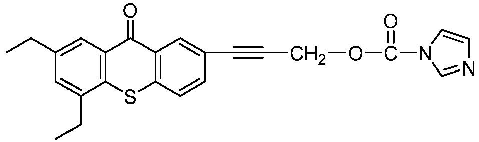

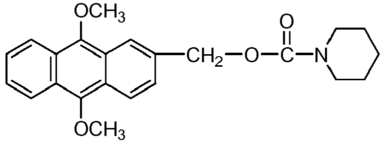

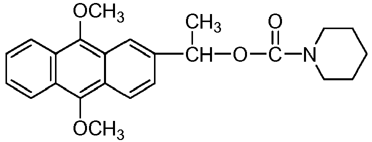

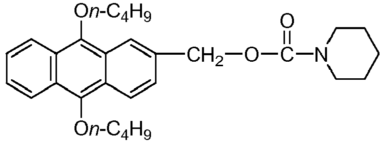

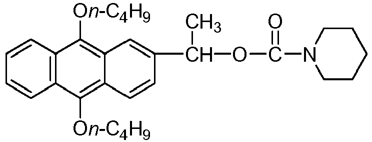

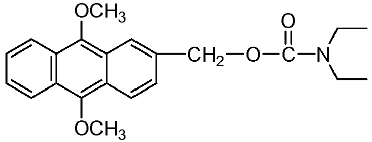

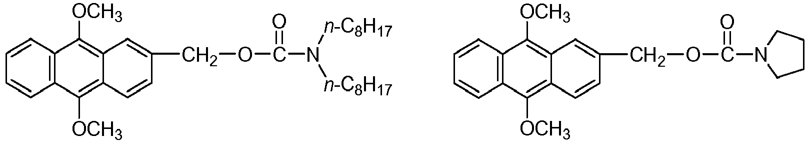

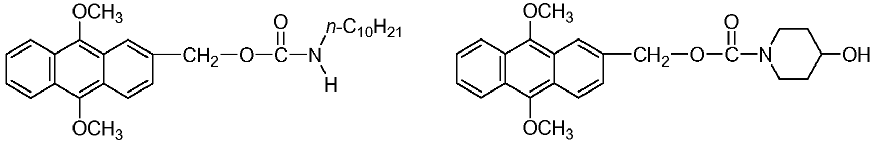

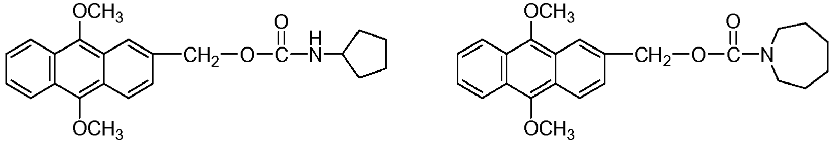

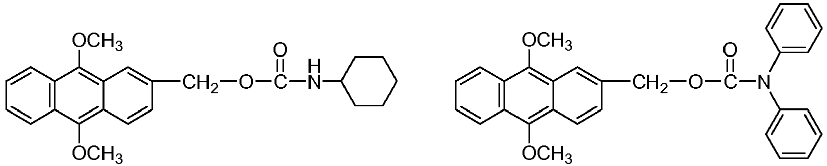

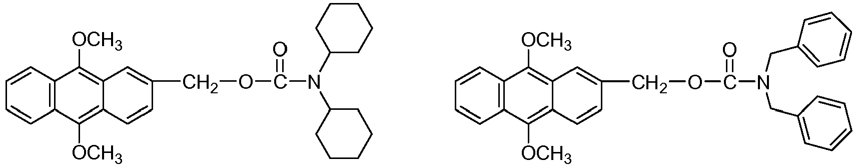

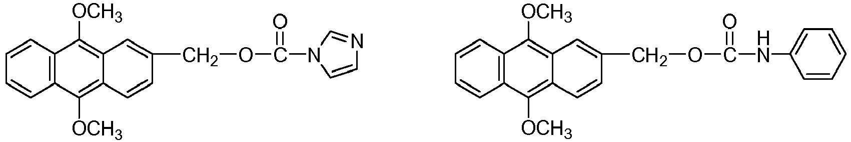

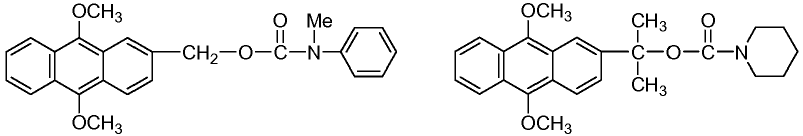

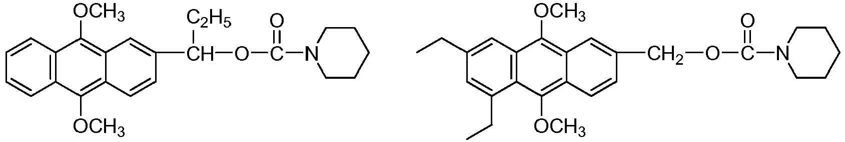

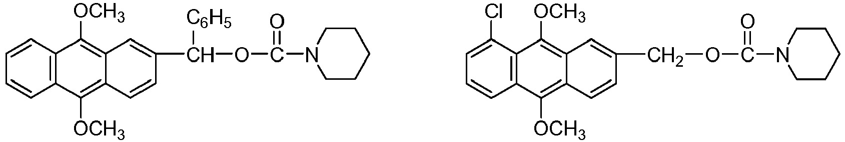

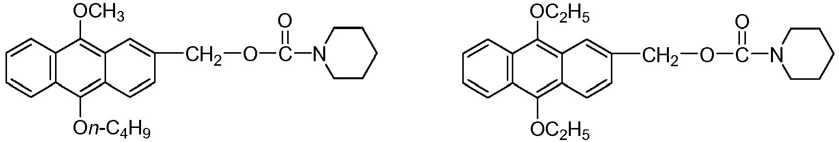

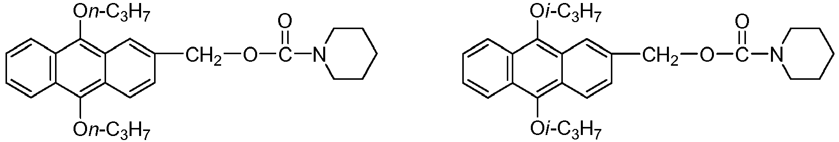

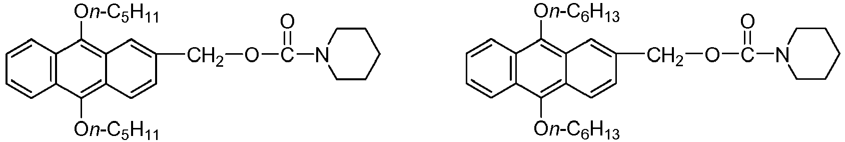

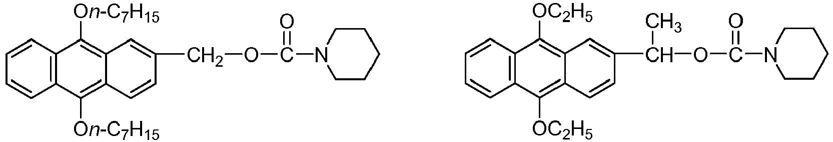

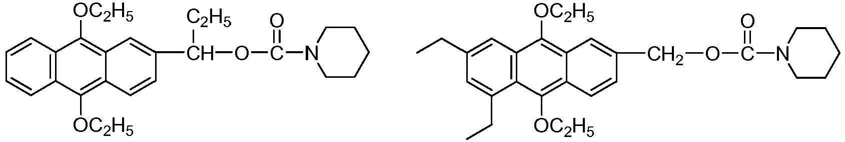

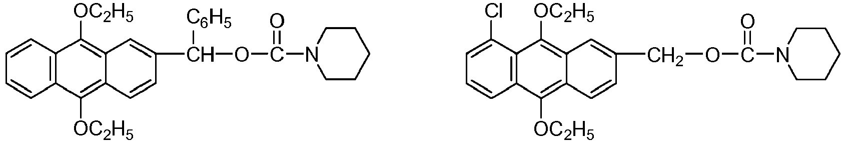

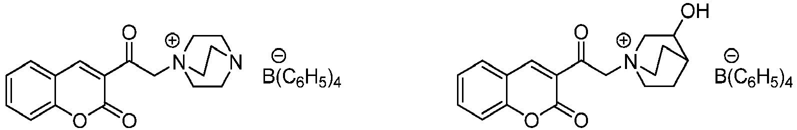

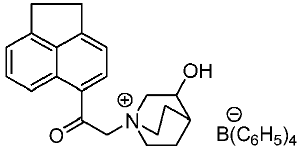

In addition, also as for, for example, the acid generating agent, the one having the similar condensed ring structure, as in the above-described base generating agent, is preferable.

As for the base or the acid generating agent, having the condensed ring structure or forming the condensed ring structure by generating the base or the acid, relevant to the present invention, only one kind among them may be used, or two or more kinds may be used in combination, as appropriate. In addition, concentration of these in the composition is usually 0.001 to 0.5 mol/L, preferably 0.001 to 0.2 mol/L, and more preferably 0.001 to 0.06 mol/L.
In addition, when shown in weight ratio, as for the one having an anthracene ring, among the base generating agents, it is 0.2 to 1 w/w%, and preferably 0.3 to 0.7 w/w%, and as for the one having an anthraquinone ring it is 0.2 to 0.6 w/w%, and preferably 0.2 to 0.5 w/w%.

As c) polar organic solvent relevant to the present invention, there is included an alcoholic protic polar organic solvent such as, for example, methanol, ethanol, n-propanol, isopropanol, n-butanol, tert-butanol, 1-methoxy-2-propanol, ethylene glycol; aprotic polar organic solvent such as, esters solvent such as, for example, ethyl acetate, n-propyl acetate, ethyl lactate, γ-butyrolactone; amides solvent such as, for example, dimethylformamide, N-methylpyrrolidone; sulfoxides solvent such as, for example, dimethylsulfoxide; nitriles solvent such as, for example, acetonitrile; cyclic ketones such as, for example, cyclohexanone.
These polar organic solvents may be selected, as appropriate, depending on objectives, and in the case of using the composition for water-repellent treatment of the present invention aiming at using in combination with water-repellent treatment of a Si-containing insulating layer such as a SiO₂ layer using, for example, hexamethyldisilazane [HMDS: bis(trimethylsilyl)amine], use of a aprotic polar organic solvent is desirable, and use of γ-butyrolactone is more desirable.
As for these polar organic solvents relevant to the present invention, only one kind may be used, or two or more kinds may be used in combination as appropriate.

A substrate whose surface can be treated to make water-repellency using the composition for water-repellent treatment of the present invention is not especially limited, as long as it is a semiconductor substrate formed with various kinds insulating layers containing Si, which is used in this field, such as a SiO₂ film (including a TEOS film or thermally-oxidized film), a SiN film, a boron-phosphorous-doped silicon film (BPSG film) or the like. The composition for water-repellent treatment of the present invention, among them, is the one, which exerts effect that both of the a Si-containing insulating layer and the metal layer of the semiconductor substrate, which has a pattern with increased height as compared with line width, that is, high aspect ratio, and that the pattern is formed by lamination with a Si-containing insulating layer such as a SiO₂ layer and a metal layer, such as, for example, a tungsten (W) film, a tungsten-titanium (W/Ti) film, an aluminum (Al) film, a titanium (Ti) film, a hafnium (Hf) film; a film formed by an alloy containing these metals; a high-k film formed by, for example, a hafnium (Hf) oxide, a hafnium-yttrium (Hf/Y) oxide, can be treated to make water-repellency at the same time. It should be noted that lamination order or lamination number or the like of the a Si-containing insulating layer and the metal layer, in the pattern formed by lamination is not especially limited, as long as it is the one usually formed in this field.

The water-repellent treatment method of the semiconductor substrate surface using the composition for water-repellent treatment of the present invention is not especially limited, as long as it is a method in which, the composition for water-repellent treatment of the present invention and the semiconductor substrate which should be treated to make water-repellency, can be contacted under light irradiation or heating, and a method usually adopted in this field, such as a dipping method or a single wafer method, has no particular problems. The temperature in water-repellent treatment is not especially limited, and in the case of generating a base or an acid by light irradiation, 10°C to 30°C is preferable, while in the case of generating a base or an acid by heating, 40°C to 80°C is preferable. The treatment time is also not especially limited, and in the case of generating a base or an acid by light irradiation, 1 to 10 minutes is suitable, while in the case in the case of generating a base or an acid by heating, 1 to 30 minutes is suitable. In addition, a light source to be used in light irradiation is also not especially limited, as long as it can irradiate light with a wavelength of 200 nm or longer (activation energy rays), more specifically, light with a wavelength of 200 nm to 500 nm (activation energy rays). For example, there is included a mercury lamp, a xenon (Xe) lamp or the like. It should be noted that light irradiation energy in this case is not especially limited, as long as it provides the amount required to release a base or an acid from the base or the acid generating agent relevant to the present invention, and usually light with a wavelength is irradiated so as to attain 40 to 100 mmJ/cm² at around 254 nm, while light with a wavelength is irradiated so as to attain 800 to 1500 mmJ/cm² at around 365 nm. In addition, after generating a base or an acid by light irradiation or heating before using the composition for water-repellent treatment of the present invention, and by making contacted with the semiconductor substrate to be treated to make water-repellency, similar water-repellent treatment can be performed. In this way, light energy amount in the case where light is irradiated, in advance, may also be set, as appropriate, in accordance with the case of simultaneous light irradiation, and heating temperature and heating time in the case of heating in advance may also be set, as appropriate, based on the above-described treatment method.

In the case of using the composition for water-repellent treatment of the present invention, by what mechanism the semiconductor substrate can be treated to make water-repellency is not necessarily clear, however, the following possibility is high. That is, it is considered that the one formed by a condensed ring compound, where two or more cationic (or anionic) or radical-type monocyclic rings (aliphatic rings or aromatic rings) are condensed, generated by structural change of a compound (or by decomposition of a compound) (along with generation of an acid or a base) by light irradiation or heating, and the long-chain alkyl tertiary amine or the long-chain alkyl ammonium salt participate in water-repellency on the substrate. Therefore, it is considered that the object of the present invention can be achieved by using compounds enabling to generate such mechanism in combination, even by other combination than the above-described specific combination.

### EXAMPLES

Explanation will be given below specifically on the present invention with reference to Experimental Example and Examples, however, the present invention should not be limited to these examples.

### Experimental Example 1.

Compositions where various kinds of reagents were combined were prepared and it was provided an investigation whether water-repellent treatment of a surface of a thermally oxidized film wafer (that is a silicon wafer having a SiO₂ layer) is possible or not.

### 1. A preparation method for an evaluation substrate.

The thermally oxidized film wafer having a size of 8 inch, put in a plastic beaker, was immersed for two hours, by charging it in 280 mL of an aqueous solution where 28% ammonia water, 35% hydrogen peroxide water and ion-exchanged water were mixed in a volume ratio of 1 : 1 : 5. After that, it was rinsed using a single wafer processing washing machine (Multispinner, manufactured by Kaijo Corp.), for 2 minutes under rotation at 800 rpm, and then spin dried for 3 minutes under rotation at 3000 rpm. After that, the wafer was cut to a size of 2 cm x 2 cm to be used as the evaluation substrate.

### 2. Preparation of an investigation composition.

Compounds described in Table 1 was dissolved each by 0.5 w/w% into γ-butyrolactone to be used as the investigation composition. It should be noted that preparation of the investigation composition was performed under a yellow lamp (FLR40SY-IC, manufactured by Mitsubishi Electric Corp.). In addition, in the following Examples, % represents w/w% in all cases.

### 3. A treatment method for the investigation composition.

20 mL of the investigation composition was put in 30 mL of a plastic beaker, in which the evaluation substrate was immersed for 1 minute under stirring and irradiating, using a ultrahigh pressure mercury lamp REX-250 (a center wavelength of 350 nm), manufactured by Asahi Spectra Co., Ltd. After that, the substrate was taken out, rinsed with pure water flow for 1 minute and dried using compressed air.

### 4. An evaluation method.

About the substrate treated with the investigation composition, contact angle was measured by automatically dropping 1 µL of pure water, using a contact angle meter (Drop master DM-501, manufactured by Kyowa Interface Science Co., Ltd.).

### 5. Results.

Measurement results of contact angle are shown in Table 1, collectively. It should be noted that structural formulae of the compounds shown by brevity codes in Table 1 are shown in Table 2.

**[Table 1]**

| | Contact angle of pure water (unit: degree) | | | | |
|---|---|---|---|---|---|
| | WPBG-015 | WBPG-058 | WBPG-082 | Sodium dodecyl sulfate | None |
| TMAH (tetramethylammonium hydroxide) | 28 | - | - | 10 | - |
| TBAH (tetra-*n*-butylammonium hydroxide) | 55 | - | - | 10 | - |
| Zephiramine* | 69 | 45 | 42 | 25 | 20 |
| TOA-Br (tetra-*n*-octylammonium bromide) | 68 | 50 | 32 | - | 20 |
| Ionic liquid 1 | 66 | - | 10 | 18 | - |
| Ionic liquid 2 | 20 | - | - | - | - |
| WPAG-413 | 30 | 27 | 24 | 10 | - |
| None | 20 | 24 | 20 | 10 | - |
| HMDS [bis(trimethylsilyl)amine] | - | - | - | - | 60 |
| Untreated (SC-1) | - | - | - | - | 6 |
| *Zephiramin: benzyldimethyl-*n*-tetradecylammonium chloride | | | | | |

**[Table 2]**

| | | |
|---|---|---|
| WPBG-015 | WPBG-058 | WPBG-082 |
| 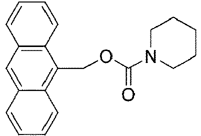 | 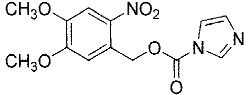 | 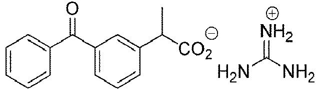 |
| Ionic liquid 1 | Ionic liquid 2 | WPAG-413 |
| 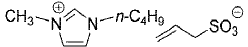 | 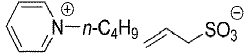 | 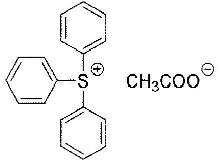 |

From the results of Table 1, it has been understood that use of a γ-butyrolactone solution containing zephiramine (benzyldimethyl-n-tetradecylammonium chloride) which is the long chain alkyl ammonium salt, and 9-anthrylmethyl 1-piperidinecarboxylate (WPBG-015) which is the base generating agent having the condensed ring structure composed of an anthracene ring, provides the highest water-repellency to the surface of the thermally oxidized film wafer. It should be noted that from the fact that contact angle of a surface after treatment with hexamethyldisilazane [HMDS: bis(trimethylsilyl)amine], which is conventional technology, was 60 degree, it was judged that a composition enabling to provide the contact angle equal to or larger than this enables to give objective contact angle of the present invention.
It should be noted that, although not shown in Table 1, investigation was performed using anthracenemethanol instead of 9-anthrylmethyl 1-piperidinecarboxylate (WPBG-015), however, even by combined use with zephiramine (benzyldimethyl-n-tetradecyl ammonium chloride), it was impossible to give water-repellency to the substrate surface.

### Example 1.

Influence of necessity of light irradiation and immersing time were investigated, in the case of using a γ-butyrolactone solution containing zephiramine (benzyldimethyl-n-tetradecylammonium chloride) which is the long chain alkyl ammonium salt, and 9-anthrylmethyl 1-piperidinecarboxylate (WPBG-015) which is the base generating agent having the condensed ring structure composed of an anthracene ring, that provided the highest water-repellency to the surface of the thermally oxidized film wafer in Experimental Example 1, as the composition for water-repellent treatment. It should be noted that, a preparation method for the evaluation substrate used, treatment of the substrate by the composition for water-repellent treatment and measurement of contact angle of pure water were performed in accordance with Experimental Example 1. Results are shown in Table 3.

**[Table 3]**

| | Contactangle of pure water (unit: degree) | |
|---|---|---|
| Immersion time (min) | WBPG-015, Without light | WBPG-015, With light |
| 0.5 | 27 | 49 |
| 1 | 30 | 69 |
| 10 | 30 | 68 |
| | | |
| Treated with HMDS | 60 | - |
| Untreated (SC-1) | 5 | - |

From the results of Table 3, it has been understood that (i) to make the substrate surface water-repellent cannot be achieved without light irradiation (OFF), and (ii) water-repellent treatment is completed by immersion for 1 minute or more under light irradiation, and effect thereof is higher than the case of treatment with hexamethyldisilazane [HMDS: bis(trimethylsilyl)amine], or the like.
Although it was understood that the substrate surface can be made water-repellent by using the composition for water-repellent treatment of the present invention, in order to confirm what kind of property is possessed in the water-repellent layer, it was confirmed how water-repellency changes, in other words, how contact angle of pure water in the substrate surface changes, in the case where the evaluation substrate obtained by immersing it for 10 minutes under light irradiation, was washed using isopropyl alcohol (IPA) and/or pure water. Results are shown in Table 4.

**[Table 4]**

| Treatment method | Contact angle of pure water (unit: degree) |
|---|---|
| IPA rinsing → Pure water rinsing for 1 min | 17 |
| Pure water rinsing | 37 |

From the results of Table 4, it has been understood that (i) there is a film removable with isopropyl alcohol (IPA), at the surface which was made water-repellent, and (ii) the film can be dissolved also with pure water, or the like.
From these facts, it is estimated that the water-repellent film formed at the substrate surface is adsorbed at the substrate surface by a force in a degree of van der Waals' force, and not by chemical bond to the substrate.

Example 2. Influence of concentrations of zephiramine (benzyldimethyl-n-tetradecylammonium chloride) and 9-anthrylmethyl 1-piperidinecarboxylate (WPBG-015) in the composition for water-repellent treatment.
Investigation was performed on influence of concentrations of zephiramine (benzyldimethyl-n-tetradecylammonium chloride) and 9-anthrylmethyl 1-piperidinecarboxylate (WPBG-015) in the composition for water-repellent treatment. Results are shown in Table 5. It should be noted that, concentrations in Table 5 represent concentration (w/w%) in γ-butyrolactone. In addition, a preparation method for the evaluation substrate used, treatment of the substrate by the composition for water-repellent treatment and measurement of contact angle of pure water were performed in accordance with Experimental

### Example 1.

**[Table 5]**

| | Zephiramine | | | |
|---|---|---|---|---|
| | 2% | 0.50% | 0.10% | 0% |
| WPBG-015 | Contact angle of pure water (unit: degree) | | | |
| 2% | 69(*) | 69(*) | 69(*) | 35 |
| 0.50% | 70 | 68 | 56 | 27 |
| 0.10% | 38 | 39 | 33 | 23 |
| 0% | 17 | 14 | 14 | 10 |
| (*) shows that the substrate surface after treatment became mottled. | | | | |

From the results of Table 5, it is considered sufficient that zephiramine (benzyldimethyl-n-tetradecylammonium chloride) is contained in 0.5%. In addition, in consideration of the fact that too high contained amount of 9-anthrylmethyl 1-piperidinecarboxylate (WPBG-015) tends to generate spots (mottles) at the substrate surface, optimum contained concentration of 9-anthrylmethyl 1-piperidinecarboxylate (WPBG-015) is considered to be around 0.5%.

### Example 3. Investigation on influence of light irradiation time.

Investigation was performed on influence of light irradiation time in water-repellent treatment. Results are shown in Table 6. It should be noted that, concentrations in Table 6 represent concentration (w/w%) in γ-butyrolactone. In addition, a preparation method for the evaluation substrate used, treatment of the substrate by the composition for water-repellent treatment and measurement of contact angle of pure water were performed in accordance with Experimental Example 1.

**[Table 6]**

| | Zephiramine | |
|---|---|---|
| | 2% | 0.50% |
| 0.5% WPBG-015 | Contact angle of pure water (unit: degree) | |
| Without light, for 3 min | 39 | 41 |
| Light irradiation for 1 min | 70 | 68 |
| Light irradiation for 3 min | 72 | 70 |
| Immersion for 3 min in solution light-irradiated for 3 min | 70 | 70 |

From the results of Table 6, it has been understood that also the case of using a solution sufficiently irradiated light before immersion provides water-repellent treatment effect similar to the case of treatment while light irradiation.

### Example 4. Water-repellent treatment of a metal film surface.

Investigation was performed whether water-repellent treatment using the composition for water-repellent treatment of the present invention is possible or not, using a silicon wafer formed with a film having W/Ti= 9:1 as the substrate. Results are shown in Table 7. It should be noted that, concentrations in Table 7 represent concentration (w/w%) in γ-butyrolactone, and "without light" means that the silicon wafer was immersed in the composition for water-repellent treatment of the present invention for 1 minute without light irradiation; "with light" means that the silicon wafer was immersed in the composition for water-repellent treatment of the present invention for 1 minute after light irradiation to the composition for 1 minute; and "while light irradiation" means that the silicon wafer was immersed in the composition for water-repellent treatment of the present invention, and from just after immersion, light was directly irradiated on the silicon wafer for 1 minute. In addition, a preparation method for the evaluation substrate, treatment of the substrate by the composition for water-repellent treatment and measurement of contact angle of pure water were performed in accordance with Experimental Example 1, except that a silicon wafer formed with a film having W/Ti= 9:1 was used as the substrate.

**[Table 7]**

| | Contact angle of pure water (unit: degree) | | |
|---|---|---|---|
| Zephiramine | 2% | 0.50% | 0% |
| 0.5% WPBG-015: Without light | 39 | 42 | 13 |
| 0.5% WPBG-015: With light | 98 | 104 | 12 |
| 0.5% WPBG-015: Immersion for 1 min while light irradiation | 97 | 102 | 17 |
| 0% WPBG-015 | 10 | 13 | 9 |
| Untreated | - | - | 8 |
| Treated with HMDS | - | - | 9 |

From the results of Table 7, it has been understood that also the W/Ti film can be made water-repellent using the composition for water-repellent treatment of the present invention.

The following facts have been understood from the results of the above Experimental Example and Examples.
1. Simultaneous treatment to make water-repellency of the Si-containing insulating layer such as the SiO₂ layer and the W film (Example was performed using the W/Ti film) by using a combination of 9-anthrylmethyl 1-piperidinecarboxylate (WPBG-015) and the long-chain alkyl quaternary ammonium salt, is possible.
2. By using the composition for water-repellent treatment of the present invention, because of enabling to make water-repellent both layers of the Si-containing insulating layer and the metal layer by one liquid, water-repellent treatment of a semiconductor substrate surface, having a pattern formed by lamination of the Si-containing insulating layer and the metal layer, is possible by a simple and convenient step, as compared with conventional technology.
3. In the composition for water-repellent treatment of the present invention, because light irradiation has a key role for exerting function as the composition for water-repellent treatment, the composition for water-repellent treatment of the present invention is possible to store for a long period of time when stored under a light shielded state.

### INDUSTRIAL APPLICABILITY

By using the composition for water-repellent treatment of the present invention and the method for water-repellent treatment of semiconductor substrate surface using the composition, because the semiconductor substrate surface, having a pattern formed by lamination of a Si-containing insulating layer and a metal layer, can be water-repellent treated by one time treatment, simply and conveniently as well as efficiently, and the water-repellent treated semiconductor substrate can prevent generation of, for example, the problem that the pattern collapses influenced by surface tension of water in a rinsing step using pure water, the composition for water-repellent treatment of the present invention and the method for water-repellent treatment of semiconductor substrate surface using the composition can be used suitably for the semiconductor substrate having such a constitution.

## Claims

1. A composition for water-repellent treatment of a semiconductor substrate surface, comprising a) at least one kind of a compound selected from the group consisting of a long-chain alkyl tertiary amine and a long-chain alkyl ammonium salt, b) a base or an acid generating agent, having a condensed ring structure or forming the condensed ring structure by generating a base or an acid and c) a polar organic solvent.

2. The composition according to claim 1, wherein the long-chain alkyl tertiary amine and the long-chain alkyl ammonium salt are those having at least one or more alkyl group having 4 to 20 carbon atoms.

3. The composition according to claim 1, wherein a) at least one kind of the compound selected from the group consisting of the long-chain alkyl tertiary amine and the long-chain alkyl ammonium salt is the long-chain alkyl ammonium salt.

4. The composition according to claim 3, wherein the long-chain alkyl ammonium salt is tri-n-octylmethylammonium chloride, tetra-n-octylammonium bromide or benzyldimethyl-n-tetradecylammonium chloride.

5. The composition according to claim 1, wherein (b) the base or the acid generating agent having the condensed ring structure, is the one having a condensed ring structure at other than a part to be a base or an acid, or forming a condensed ring structure by generating a base or an acid, by light irradiation or heating.

6. The composition according to claim 5, wherein the condensed ring structure is an anthracene ring, a naphthalene ring, a pyrene ring, an anthraquinone ring, a thioxanthone ring, an acenaphthene ring, a coumarin ring, or a xanthone ring.

7. The composition according to claim 5, wherein the condensed ring structure is the anthracene ring.

8. The composition according to claim 1, wherein b) the base or the acid generating agent having the condensed ring structure or forming the condensed ring structure by generating the base or the acid, is 9-anthrylmethyl-1-piperidinecarboxylate.

9. The composition according to claim 1, wherein c) the polar organic solvent is aprotic.

10. The composition according to claim 1, wherein c) the polar organic solvent is γ-butyrolactone.

11. A method for water-repellent treatment of a semiconductor substrate surface, **characterized by** treating the semiconductor substrate having a pattern formed by lamination of a Si-containing insulating layer and a metal layer, using the composition according to claim 1, under irradiation of light having a wavelength of 200 nm or longer, or under heating.

12. The method according claim 11, wherein the metal layer is the one formed of tungsten, aluminum, titanium, hafnium, an alloy containing these metals, a hafnium oxide or a hafnium-yttrium oxide.
